Europäisches Patentamt

European Patent Office

Office européen des brevets

(11) Numéro de publication: **0 379 449**
**A1**

## (12) DEMANDE DE BREVET EUROPEEN

(21) Numéro de dépôt: **90420019.3**

(22) Date de dépôt: **12.01.90**

(51) Int. Cl.5: **H01L 21/82**

(30) Priorité: **17.01.89 FR 8901228**

(43) Date de publication de la demande:
**25.07.90 Bulletin 90/30**

(84) Etats contractants désignés:
**DE FR GB IT NL**

(71) Demandeur: **SGS-THOMSON**
**MICROELECTRONICS S.A.**
**7, Avenue Galliéni**
**F-94250 Gentilly(FR)**

(72) Inventeur: **Guillaumot, Bernard**
**14, Rue du Rocher**
**F-38120 Le Fontanil(FR)**
Inventeur: **Bergemont, Albert**
**26, Chemin de Maubec**
**F-38700 La Tronche(FR)**

(74) Mandataire: **de Beaumont, Michel**
**1bis, rue Champollion**
**F-38000 Grenoble(FR)**

(54) Procédé de fabrication de circuits intégrés.

(57) La présente invention concerne un procédé de fabrication de circuits intégrés de type MOS qui comportent des transistors à grille flottante de mémoire, des transistors haute tension et des transistors logiques. Une première couche d'oxyde de grille (3) est réalisée. Un premier niveau de silicium polycristallin (4) et une couche d'isolement (5) sont déposés On grave la couche d'isolement (5), le premier niveau de silicium polycristallin (4) et la couche d'oxyde de grille (3) à l'emplacement des transistors logiques. On réalise une deuxième couche d'oxyde de grille (16), et un deuxième niveau de silicium polycristallin (17) est déposé. L'épaisseur de la couche d'oxyde de grille (16) des transistors logiques est inférieure à celle des transistors de mémoire et des transistors haute tension, les transistors logiques supportant une tension de 3,3 volts inférieure à la tension standard de 5 volts.

Figure 4

## PROCÉDÉ DE FABRICATION DE CIRCUITS INTÉGRÉS

La présente invention concerne le domaine de la fabrication des circuits intégrés.

Plus précisément, la présente invention vise à fournir un procédé de fabrication simultanée de transistors à grille flottante de mémoires non-volatiles électriquement programmables (mémoires EPROM), de transistors haute tension et de transistors logiques, dans lequel les transistors logiques et les transistors de mémoire possèdent une longueur de canal très faible de 500 nm, alors que la longueur de canal des transistors haute tension est de l'ordre de 800 à 1000 nm.

Dans un tel assemblage, la présente invention prévoit de choisir des transistors logiques comportant une épaisseur d'oxyde de grille inférieure à celle des transistors de mémoire et des transistors haute tension, les transistors logiques supportant une tension de 3,3 volts.

Dans les circuits usuels, la tension appliquée aux transistors logiques est de 5 volts, ce qui présente l'inconvénient d'un vieillissement accéléré des transistors par piégeage de porteurs chauds dans l'oxyde de grille lorsque les dimensions de longueur de canal descendent à 500 nm.

La diminution de la tension à 3,3 volts est par exemple obtenue en réalisant un réducteur de tension intégré au circuit.

Le courant entre le drain et la source d'un transistor MOS est inversement proportionnel à l'épaisseur de la couche d'oxyde de grille. L'abaissement de l'épaisseur de la couche d'oxyde de grille des transistors logiques permet de conserver une valeur de courant notable et des bonnes performances.

Les transistors de mémoire et les transistors haute tension supportent une tension de, par exemple, 10 volts.

Pour atteindre ces objets, la présente invention prévoit un procédé de fabrication de circuits intégrés de type MOS qui comportent des transistors à grille flottante de mémoire, des transistors haute tension et des transistors logiques, comprenant les étapes suivantes :

a) réaliser des zones d'oxyde épais entre les emplacements des transistors,

b) réaliser une première couche d'oxyde de grille entre les zones d'oxyde épais,

c) déposer un premier niveau de silicium polycristallin et une couche d'isolement,

d) graver dans la zone mémoire des bandes du bicouche, couche d'isolement et premier niveau de silicium polycristallin,

e) isoler latéralement, dans la zone mémoire, les régions apparentes de premier niveau de silicium polycristallin (flancs de silicium polycristallin),

f) graver la couche d'isolement, le premier niveau de silicium polycristallin et la première couche d'oxyde de grille à l'emplacement des transistors logiques,

g) réaliser une deuxième couche d'oxyde de grille et déposer un deuxième niveau de silicium polycristallin,

h) graver le deuxième niveau de silicium polycristallin et la couche d'isolement à l'emplacement des transistors haute tension,

i) graver simultanément le deuxième niveau de silicium polycristallin dans la zone mémoire et à l'emplacement des transistors logiques et le premier niveau de silicium polycristallin à l'emplacement des transistors haute tension,

j) graver dans la zone mémoire à l'aplomb du deuxième niveau de silicium polycristallin gravé à l'étape précédente la couche d'isolement et le premier niveau de silicium polycristallin,

k) réaliser par implantation les sources et drains des différents transistors, et

l) déposer une couche d'isolant et établir des contacts de zone mémoire, de transistors haute tension et de transistors logiques.

Ces objets, caractéristiques et avantages ainsi que d'autres de la présente invention seront exposés plus en détail dans la description suivante d'un mode de réalisation particulier faite en relation avec les figures jointes 1 à 4 qui représentent des étapes d'un procédé de fabrication de circuits intégrés selon l'invention.

De façon générale, comme cela est classique dans la représentation des circuits intégrés, on notera que les diverses figures ne sont pas représentées à l'échelle ni d'une figure à l'autre, ni à l'intérieur d'une figure, et notamment que les épaisseurs des couches sont dessinées arbitrairement dans le but de faciliter la lecture des figures.

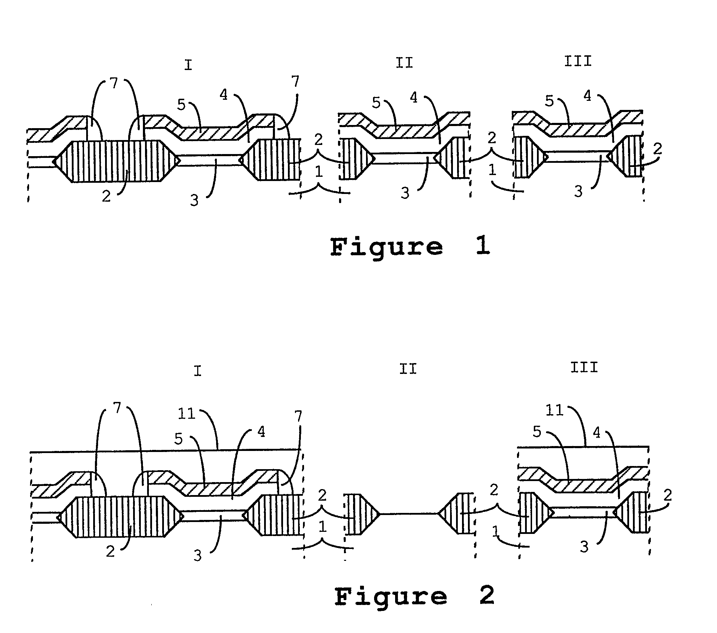

La figure 1 représente, à une étape de fabrication intermédiaire, une vue en coupe d'un circuit intégré comprenant des transistors à grille flottante de mémoire EPROM (partie I), des transistors logiques (partie II) et des transistors haute tension (partie III). Les dispositifs sont réalisés sur un substrat 1. Des zones d'oxyde épais 2 ont été formées entre les emplacements des transistors. Entre chaque zone d'oxyde épais 2 a été réalisée une première couche d'oxyde de grille 3. Un premier niveau de silicium polycristallin 4 et une couche d'isolement 5 ont été déposés. Cette couche d'isolement 5 et ce premier niveau de silicium polycristallin 4 ont été gravés dans la zone mémoire pour définir une bande du bicouche, couche d'isolement sur premier niveau de silicium polycristallin. Une zone d'oxyde 7, appelée zone d'oxyde de coin, a été réalisée dans la zone mémoire au niveau des bords latéraux apparents du premier niveau de silicium polycristallin 4.

Les zones d'oxyde épais 2 ont par exemple une épaisseur de 700 nm et les couches d'oxyde de grille 3 ont par exemple une épaisseur de 20 nm.

La couche d'isolement 5 est constituée par exemple par un empilement de trois niveaux : Oxyde de silicium/Nitrure de silicium/Oxyde de silicium, désigné par ONO.

La figure 2 représente le circuit après masquage avec une résine photosensible 11 de la zone mémoire et de l'emplacement des transistors haute tension, et après gravure de la couche d'isolement 5, du premier niveau de silicium polycristallin 4 et de la couche d'oxyde de grille 3 à l'emplacement des transistors logiques.

La résine 11 est ensuite éliminée.

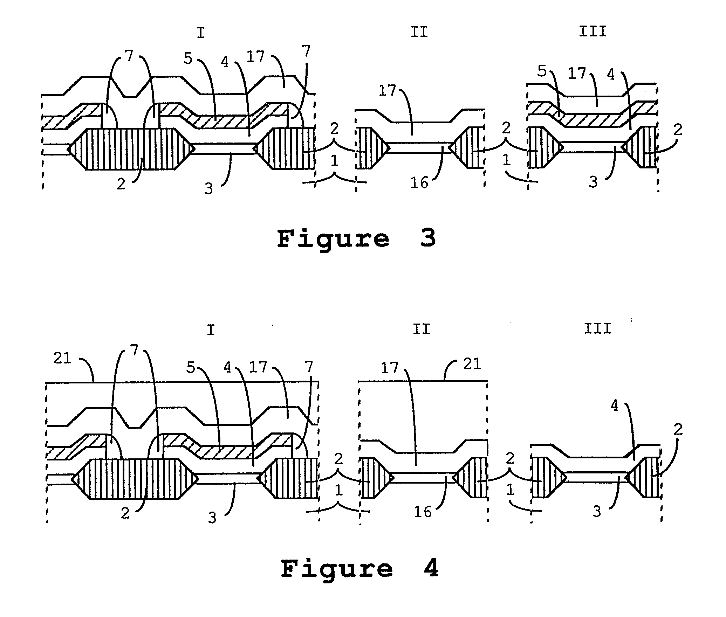

A l'étape de la figure 3, on a réalisé une deuxième couche d'oxyde de grille 16 (dans la zone mémoire et à l'emplacement des transistors haute tension, cette couche d'oxyde de grille 16 se confond avec la couche d'isolement 5 et elle n'est pas repré sentée) et déposé un deuxième niveau de silicium de polycristallin 17.

La couche d'oxyde de grille 16 a par exemple une épaisseur de 12 nm.

Les zones d'oxyde de coin 7 permettent d'isoler dans la zone mémoire le deuxième niveau de silicium polycristallin 17 des flancs du premier niveau de silicium polycristallin 4.

A l'étape de la figure 4, la zone mémoire et l'emplacement des transistors logiques ont été masqués avec une résine photosensible 21, et le deuxième niveau de silicium polycristallin 17 et la couche d'isolement 5 ont été gravés à l'emplacement des strantsistors haute tension.

La résine 21 est ensuite éliminée.

Dans la suite du procédé, on grave simultanément le deuxième niveau de silicium polycristallin 17 dans la zone mémoire et à l'emplacement des transistors logiques et le premier niveau de silicium polycristallin 4 à l'emplacement des transistors haute tension. Les bandes de deuxième niveau de silicium polycristallin 17 ainsi formées dans la zone mémoire constituent les lignes de mot de la mémoire EPROM. Dans cette zone mémoire, on grave ensuite à l'aplomb des lignes de mot la couche d'isolement 5 et le premier niveau de silicium polycristallin 4 pour former les grilles flottantes des transistors de mémoire.

Les régions de sources et de drains des différents transistors du circuit sont réalisées par implantation. Une couche d'isolant est déposée sur l'ensemble du circuit et les contacts de zone mémoire, de transistors haute tension et de transistors logiques sont établis.

Ce procédé de fabrication est avantageusement complété par un dépôt, avant la gravure simultanée selon des rangées du deuxième niveau de silicium polycristallin 17 dans la zone mémoire et à l'emplacement des transistors logiques et du premier niveau de silicium polycristallin 4 à l'emplacement des transistors haute tension, d'une couche supplémentaire de siliciure pour améliorer notamment les caractéristiques électriques associées au niveau de silicium polycristallin placé sous cette couche.

**Revendications**

1. Procédé de fabrication de circuits intégrés de type MOS qui comportent des transistors à grille flottante de mémoire, des transistors haute tension et des transistors logiques, comprenant les étapes suivantes :

a) réaliser des zones d'oxyde épais (2) entre les emplacements des transistors,

b) réaliser une première couche d'oxyde de grille (3) entre les zones d'oxyde épais (2),

c) déposer un premier niveau de silicium polycristallin (4) et une couche d'isolement (5),

d) graver dans la zone mémoire des bandes du bicouche, couche d'isolement (5) et premier niveau de silicium polycristallin (4),

e) isoler latéralement (7), dans la zone mémoire, les régions apparentes de premier niveau de silicium polycristallin (4) (flancs de silicium polycristallin),

caractérisé en ce qu'il comprend en outre les étapes suivantes :

f) graver la couche d'isolement (5), le premier niveau de silicium polycristallin (4) et la première couche d'oxyde de grille (3) à l'emplacement des transistors logiques,

g) réaliser une deuxième couche d'oxyde de grille (16) et déposer un deuxième niveau de silicium polycristallin (17),

h) graver le deuxième niveau de silicium polycristallin (17) et la couche d'isolement (5) à l'emplacement des transistors haute tension,

i) graver simultanément le deuxième niveau de silicium polycristallin (17) dans la zone mémoire et à l'emplacement des transistors logiques et le premier niveau de silicium polycristallin (4) à l'emplacement des transistors haute tension,

j) graver dans la zone mémoire à l'aplomb du deuxième niveau de silicium polycristallin (17) gravé à l'étape précédente, la couche d'isolement (5) et le premier niveau de silicium polycristallin (4),

k) réaliser par implantation les sources et drains des différents transistors, et

l) déposer une couche d'isolant et établir des contacts de zone mémoire, de transistors haute tension et de transistors logiques.

2. Procédé de fabrication de circuits intégrés selon la revendication 1, caractérisé en ce qu'une couche supplémentaire formée d'un matériau siliciure est déposée avant la réalisation de l'étape i.

3. Procédé de fabrication de circuits intégrés selon la revendication 1, caractérisé en ce que la couche d'isolement (5) est constituée par un empilement de trois niveaux : Oxyde de silicium/Nitrure de silicium/Oxyde de silicium.

I II III

Figure 1

EP 0 379 449 A1

I II III

Figure 2

**Figure 3**

**Figure 4**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN, vol. 11, no. 277 (E-538)[2724], 8 septembre 1987; & JP-A-62 76 668 (TOSHIBA CORP.) 08-04-1987 * Résumé; figures * | 1 | H 01 L 21/82 |
| A | PATENT ABSTRACTS OF JAPAN, vol. 6, no. 205 (E-136)[1083], 16 octobre 1982; & JP-A-57 113 278 (FUJITSU K.K.) 14-07-1982 * Résumé; figures * | 1 | |
| A | PATENT ABSTRACTS OF JAPAN, vol. 11, no. 195 (E-518)[2642], 23 juin 1987; & JP-A-62 23 151 (HITACHI LTD) 31-01-1987 * Résumé; figure * | 1 | |
| A | EP-A-0 206 929 (C.E.A.) * Page 6, ligne 37 - page 8, ligne 57; figures 1-8 * | 1-3 | |
| A | DE-A-3 107 543 (HITACHI LTD) * Figures 19-25; résumé * | 1 | DOMAINES TECHNIQUES RECHERCHES (Int. Cl.5)  H 01 L |

Le présent rapport a été établi pour toutes les revendications

| Lieu de la recherche | Date d'achèvement de la recherche | Examinateur |
|---|---|---|
| LA HAYE | 09-04-1990 | GELEBART J.F.M. |